# FASCICULE DE BREVET EUROPEEN

(11) **EP 4 255 134 B1**
(45) Date de publication et mention de la délivrance du brevet: **15.01.2025**
(21) Numéro de dépôt: 23160873.8
(22) Date de dépôt: 09.03.2023
(51) Int. Cl.: H05K 5/00, H05K 5/02, H05K 7/14

(54) **BÂTI D'ÉQUIPEMENT ELECTRONIQUE COMPORTANT UNE PIÈCE DE RENFORT POUR PROTÉGER UN CIRCUIT IMPRIMÉ**
GEHÄUSE FÜR ELEKTRONISCHE AUSRÜSTUNG MIT VERSTÄRKUNGSTEIL ZUM SCHUTZ EINER LEITERPLATTE
ELECTRONIC EQUIPMENT RACK COMPRISING A REINFORCING PIECE FOR PROTECTING A PRINTED CIRCUIT BOARD

(30) Priorité: 28.03.2022 FR 2202732
(43) Date de publication de la demande: 04.10.2023
(73) Titulaire: Airbus Operations SAS, 31060 Toulouse (FR)
(72) Inventeur: FERNANDEZ RAMOS, Yvan, 31060 Toulouse (FR); PELLIZZON, Sébastien, 31060 Toulouse (FR); PEREZ, Benoît, 31700 Blagnac (FR)
(74) Mandataire: Gevers & Orès

(56) Documents cités:
- WO-A1-2020/249258
- JP-A- H04 290 498
- US-A- 5 348 482

## Description

### Domaine technique

La présente invention concerne un bâti d'équipement électrique destiné à l'installation de calculateurs, en particulier dans une baie d'équipement électrique d'un aéronef.

### Etat de la technique

Les aéronefs comprennent de nombreuses fonctions électriques, en particulier des commandes de vol électriques. Ces fonctions sont commandées, tout ou en partie, par des calculateurs qui sont installés dans des baies d'équipement électrique. Ces baies d'équipement électrique comportent généralement des bâtis d'équipement électriques (aussi appelés racks avioniques) destinés à recevoir les calculateurs. Les bâtis d'équipement électrique comprennent notamment des connecteurs permettant de connecter les calculateurs aux systèmes électriques de l'aéronef. Ces connecteurs sont raccordés à différents équipements comme des harnais électriques. De tels harnais électriques sont généralement lourds et encombrants. Il peut être avantageux de les remplacer par des équipements plus légers et plus compacts comme des circuits imprimés. Cependant, ces dernières présentent l'inconvénient d'être plus fragiles. Or, les calculateurs ou la structure des bâtis d'équipement électrique peuvent générer des charges mécaniques sur les connecteurs, qui sont transmises directement aux circuits imprimés et qui sont susceptibles d'endommager ces circuits imprimés. Un bâti selon l'état de la technique est décrit dans le document WO 2020/249258 A1.

Par conséquent, il existe un besoin de trouver une solution pour améliorer le remplacement des harnais électriques par des circuits imprimés dans des bâtis d'équipement électrique.

### Exposé de l'invention

La présente invention concerne un bâti d'équipement électrique pour recevoir au moins un calculateur, le bâti d'équipement électrique comportant au moins un châssis sur lequel le calculateur est destiné à être installé et un circuit imprimé pourvu d'au moins un connecteur fixé au châssis et auquel le calculateur est destiné à être connecté lorsque ledit calculateur est installé sur le châssis.

Selon l'invention, le bâti d'équipement électrique comporte au moins une pièce de renfort agencée, au moins en partie, entre le connecteur et le châssis, la pièce de renfort étant configurée pour rediriger des efforts que le calculateur et/ou le châssis exercent sur le connecteur, afin de ne pas transmettre lesdits efforts au circuit imprimé.

Ainsi, grâce à l'invention, on dispose d'un bâti d'équipement électrique renforcé au niveau de l'interface entre le connecteur et le calculateur par la pièce de renfort. Cela permet d'éviter au calculateur et/ou au châssis de transmettre des efforts au circuit imprimé via le connecteur et donc d'éviter de l'endommager.

De plus, de façon avantageuse, la pièce de renfort présente au moins une paroi principale plane agencée contre le châssis, la paroi principale présentant un évidement pour le passage du connecteur à travers ladite pièce de renfort.

Dans un mode de réalisation préféré, la pièce de renfort comporte au moins une paroi latérale sensiblement perpendiculaire à la paroi principale.

Avantageusement, la paroi latérale présente au moins un bord latéral incliné.

En outre, de façon avantageuse, la paroi latérale s'étend sur au moins une portion du pourtour de la paroi principale.

Par ailleurs, dans un mode de réalisation, le bâti d'équipement électrique comporte au moins un élément de fixation pour fixer à la fois la pièce de renfort et le connecteur au châssis.

De plus, dans un mode de réalisation particulier, le bâti d'équipement électrique comporte une pluralité de châssis, au moins un connecteur étant fixé à chacun des châssis, et au moins une pièce de renfort est agencée entre chaque châssis et le ou les connecteurs fixés audit châssis.

Selon l'invention, les pièces de renfort du bâti d'équipement électrique sont liées ensemble. Avantageusement, lesdites pièces de renfort liées ensemble forment une unité monobloc.

### Brève description des figures

Les figures annexées feront bien comprendre comment l'invention peut être réalisée. Sur ces figures, des références identiques désignent des éléments semblables.
La figure 1 est une vue en perspective d'une vue de face d'un bâti d'équipement électrique selon un premier mode de réalisation comportant une pièce de renfort agencée entre un connecteur et un châssis.
La figure 2 est une vue en coupe du bâti d'équipement électrique selon le premier mode de réalisation.
La figure 3 est une vue partielle en coupe du bâti d'équipement électrique selon le premier mode de réalisation agrandie au niveau de l'interface entre le connecteur et la pièce de renfort.
La figure 4 est une vue en perspective d'une face avant d'un bâti d'équipement électrique selon un second mode de réalisation comportant trois châssis et une pièce de renfort monobloc.
La figure 5 est une vue en perspective d'une face arrière du bâti d'équipement électrique de la figure 4.

### Description détaillée

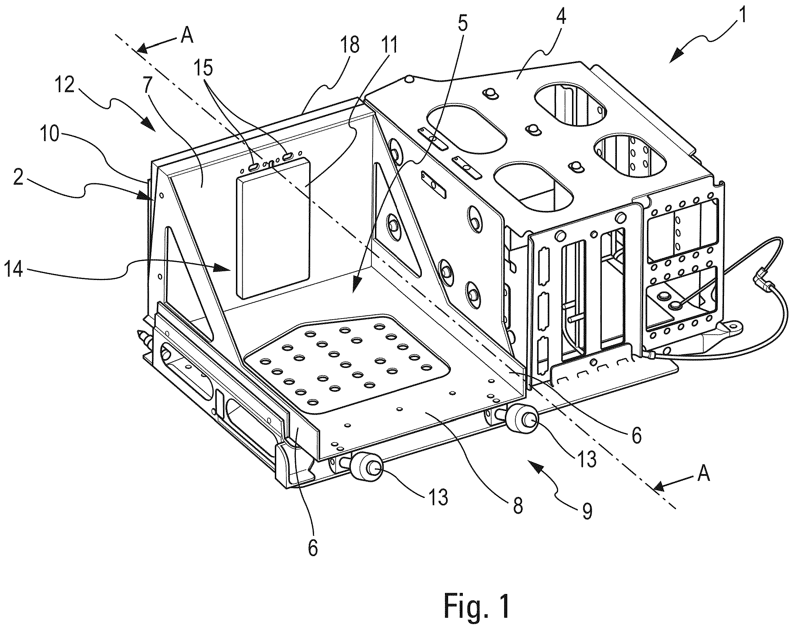

Le bâti 1 d'équipement électrique (nommé « bâti 1 » dans la suite de la description) représenté schématiquement dans des modes de réalisation particuliers de la figure 1 à la figure 5 et permettant d'illustrer l'invention est destiné à recevoir au moins un calculateur.

Le bâti 1 est particulièrement adapté à l'installation de calculateurs dans un aéronef, en particulier un avion de transport. Dans le domaine aéronautique, un tel bâti 1 (aussi appelé « rack avionique ») peut être installé dans une baie d'équipement électrique abritant plusieurs bâtis d'équipement électrique ce qui permet de regrouper des calculateurs de l'aéronef au même endroit.

On entend par « calculateur » un système électronique réalisé sous la forme d'un module indépendant et amovible qui est destiné à commander des fonctions électriques. Il présente au moins une interface de connexion permettant de le connecter à un bâti d'équipement électrique comme décrit ci-après.

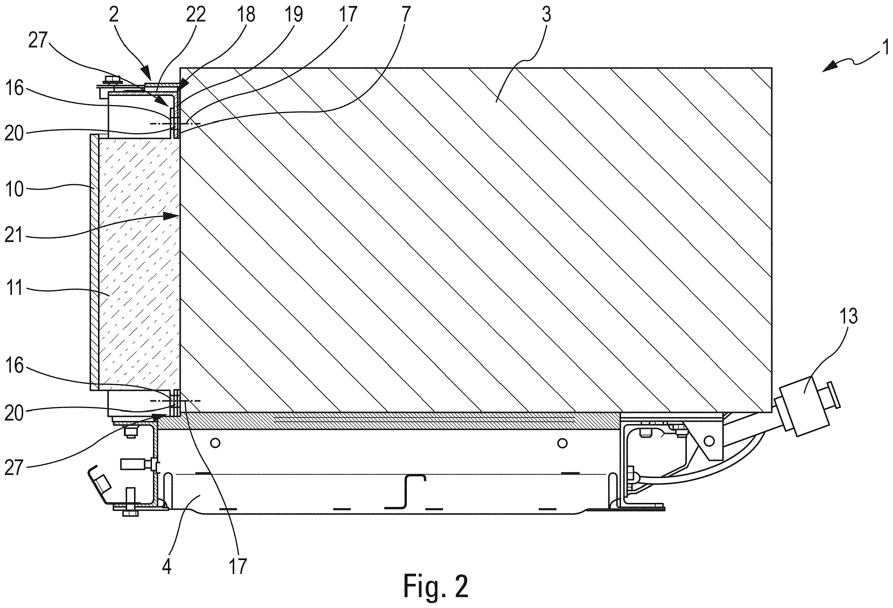

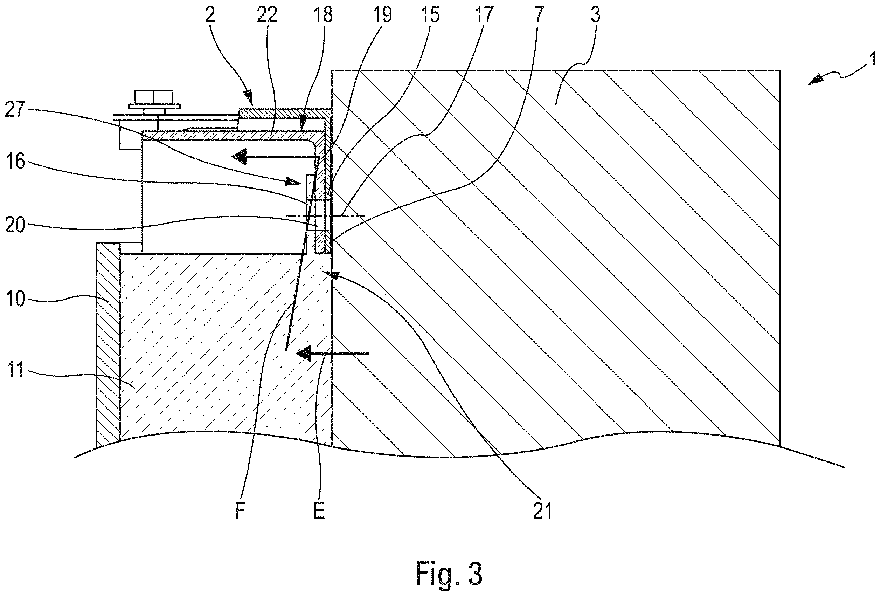

Le bâti 1, comme illustré sur la figure 1, comporte un châssis 2 destiné à recevoir un calculateur 3 (représenté uniquement sur la figure 2 et la figure 3). Le châssis 2 est fixé sur un support 4. Le support 4 peut notamment servir à agencer le bâti 1 dans une structure, par exemple dans une baie d'équipement électrique via des rails et/ou des éléments de fixation usuels.

Le châssis 2 comporte un logement 5 configuré pour recevoir le calculateur 3. Le logement 5 présente une forme rectangulaire adaptée à la forme d'un calculateur standard, de préférence un calculateur avionique. Le rectangle formé par le logement 5 comprend deux segments latéraux 6, une paroi arrière 7 et une ouverture 8. L'ouverture 8 est orientée vers une face avant 9 du bâti 1 notamment visible sur la figure 1. L'ouverture 8 est configurée pour permettre au calculateur 3 d'être inséré dans le logement 5 en étant poussé vers la paroi arrière 7.

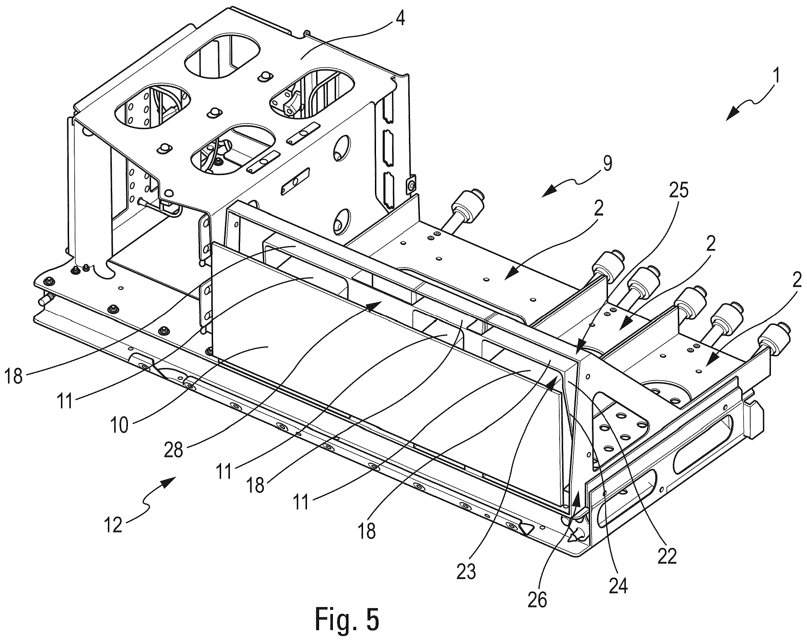

En outre, le bâti 1 comporte un circuit imprimé 10 pourvu d'un connecteur 11 représenté schématiquement par une forme rectangulaire de la figure 1 à la figure 5. Le circuit imprimé10 est agencé au niveau d'une face arrière 12 du bâti 1 notamment visible sur la figure 5. Par ailleurs, le circuit imprimé 10 est lié aux fonctions électriques que le calculateur 3 est destiné à commander.

Le calculateur 3 est destiné à être connecté au connecteur 11 afin d'assurer la liaison électrique entre ledit calculateur 3 et le circuit imprimé10. Il comporte, de façon usuelle, une interface de connexion (non représentée sur les figures) adaptée au connecteur 11. Le calculateur 3 peut notamment être mis en position dans le logement 5 du châssis 2 par le connecteur 11 via cette interface de connexion. Le châssis 2 comporte également des verrous 13 (figure 1 et figure 2) au niveau de l'ouverture 8 afin de maintenir le calculateur 3 en position dans le logement 5 lorsqu'il est connecté au connecteur 11.

De plus, la paroi arrière 7 du châssis 2 comporte un orifice 14 (figure 1) permettant le passage du connecteur 11 à travers ladite paroi arrière 7. Le châssis 2 et le connecteur 11 présentent, respectivement, des trous de fixation 15 et des trous de fixation 16 pour des éléments de fixation 17 usuels (représentés schématiquement par des traits mixtes sur la figure 2 et la figure 3) afin de fixer le connecteur 11 au châssis 2. L'ensemble comprenant le châssis 2, le calculateur 3, le connecteur 11 et les éléments de fixation 17 peut être régit par des normes usuelles ARINC, comme par exemple la norme ARINC600.

Dans un premier mode de réalisation, représenté de la figure 1 à la figure 3, le bâti 1 comporte une pièce de renfort 18 agencée au niveau de la face arrière 12 du châssis 2. Comme détaillé sur la figure 2 et la figure 3, représentant des vues en coupe du bâti 1 selon une ligne de coupe A-A, la pièce de renfort 18 est intercalée entre le connecteur 11 et le châssis 2. De plus, la pièce de renfort 18 est fixée à la fois au connecteur 11 et au châssis 2. Pour ce faire, la pièce de renfort 18 comporte au moins une paroi principale 19 plane agencée contre la paroi arrière 7 du châssis 2. La paroi principale 19 est pourvue de trous de fixation 20 pour la fixation de la pièce de renfort 18 au connecteur 11 et au châssis 2 par des éléments de fixation usuels.

La pièce de renfort 18 ainsi agencée permet de rediriger des efforts, représentés par une flèche E sur la figure 3, que le calculateur 3 et/ou le châssis 2 exercent sur le connecteur 11 afin de ne pas transmettre lesdits efforts au circuit imprimé 10. Ces efforts sont transmis à la pièce de renfort 18 en passant par le connecteur 11 comme représenté par une flèche F sur la figure 3. Les efforts provenant du calculateur 3 et/ou du châssis 2 n'atteignent donc pas le circuit imprimé 10 qui ne présente alors pas de risque d'être endommagé.

De préférence, la pièce de renfort 18 peut correspondre à une tôle réalisée en matériau métallique.

Ainsi, grâce à la pièce de renfort 18, on obtient un bâti d'équipement électrique renforcé au niveau de l'interface entre le connecteur 11 et le calculateur 3. Le bâti 1 ne transmet donc pas d'efforts au circuit imprimé 10 via le connecteur 11. Il ne transmet notamment pas d'efforts provenant d'au moins l'un des éléments suivants : le calculateur 3, le châssis 2 (y compris les éléments du châssis 2, à savoir par exemple le logement 5). Le bâti 1 peut comporter un circuit imprimé sans risque d'endommager ledit circuit imprimé. Le bâti 1 pouvant être équipé d'un circuit imprimé à la place d'un harnais électrique est par conséquent léger et peu encombrant.

De plus, la pièce de renfort 18 est adaptée pour renforcer tout type de bâti d'équipement électrique standard. En effet, elle peut facilement être conçue avec une forme adaptée à des bâtis d'équipement électrique variés. Par ailleurs, cette solution de renfort est peu coûteuse, notamment car elle évite d'avoir à concevoir une nouvelle forme pour le châssis.

En outre, comme représenté sur la figure 2 et la figure 3, la pièce de renfort 18 présente, sur la paroi principale 19, un évidement 21 pour le passage du connecteur 11. L'évidement 21 est configuré pour être en regard de l'orifice 14 permettant le passage du connecteur 11 à la fois à travers la pièce de renfort 18 et le châssis 2.

De plus, dans un mode de réalisation particulier représenté de la figure 1 à la figure 3, la pièce de renfort 18 comporte une paroi latérale 22. De préférence, la paroi latérale 22 correspond à un prolongement sensiblement perpendiculaire à ladite paroi principale 19 situé à la périphérie de la pièce de renfort 18. Elle peut notamment présenter la même épaisseur que la paroi principale 19. Toutefois, dans des variantes (non représentées) de ce mode de réalisation, la paroi latérale 22 peut présenter des formes et des orientations variées. Elle peut également correspondre à un prolongement de la paroi principale 19 situé sur une autre partie que la périphérie de la pièce de renfort 18, par exemple en formant une nervure.

Dans un mode de réalisation particulier, représenté de la figure 1 à la figure 5, la paroi latérale 22 présente une extrémité libre 23 située sur une face de la pièce de renfort 18 opposée à la paroi principale 19. La paroi latérale 22 comporte sur sa périphérie au niveau de l'extrémité libre 23 un bord latéral 24 incliné (notamment visible sur la figure 5). De préférence, comme représenté sur la figure 5, le bord latéral 24 est configuré de sorte que la paroi latérale 22 forme un biseau sur au moins une partie de l'extrémité libre 23. Ainsi, la paroi latérale 22 présente une largeur diminuant depuis une extrémité supérieure 25 du châssis 2 vers une extrémité inférieure 26 du châssis 2. Cette forme inclinée particulière du bord latéral 24 peut permettre d'obtenir une rigidité de la pièce de renfort 18 différente à certains endroits précis, à savoir dans le cas présent une rigidité plus forte à l'extrémité supérieure 25 qu'à l'extrémité inférieure 26.

Toutefois, le bord latéral 24 peut présenter des formes variées autre qu'une forme inclinée, et notamment des formes permettant d'obtenir une rigidité adaptée à la géométrie d'un bâti d'équipement électrique à renforcer.

Dans un autre mode de réalisation particulier, représenté de la figure 1 à la figure 5, la paroi latérale 22 s'étend sur le pourtour de la paroi principale 19. La paroi latérale 22 peut notamment s'étendre sur une portion du pourtour de la paroi principale 19. De préférence, la paroi latérale 22 s'étend sur la totalité du pourtour de la paroi principale 19. La paroi latérale 22 ainsi étendue permet d'obtenir une pièce de renfort 18 avec une rigidité renforcée sur la totalité du pourtour de la paroi principale 19 ou seulement sur des portions ciblées.

Par ailleurs, le bâti 1 comporte des éléments de fixations pour fixer à la fois la pièce de renfort 18 et le connecteur 11 au châssis 2. Dans le mode de réalisation, représenté sur la figure 2 et la figure 3, le connecteur 11 comporte des pattes 27 dans lesquelles sont pratiqués les trous de fixation 16. La pièce de renfort 18 est agencée entre les pattes 27 du connecteur 11 et le châssis 2. De plus, les pattes 27 sont configurées de sorte que les trous de fixation 15, 16 et 20 coïncident. Ils permettent ainsi de fixer à la fois le connecteur 11 et la pièce de renfort 18 au châssis 2 par l'intermédiaire des éléments de fixation 17.

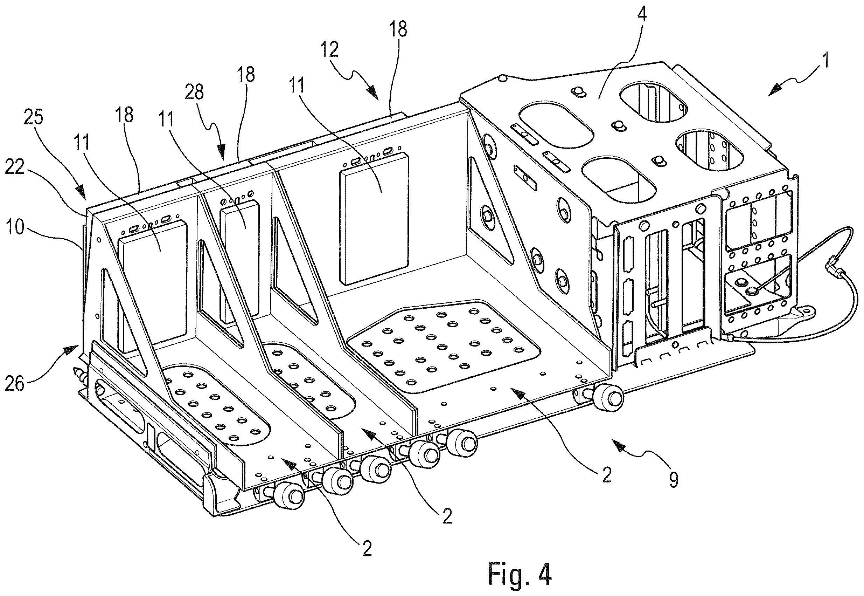

Dans un second mode de réalisation représenté sur la figure 4 et la figure 5, le bâti 1 comporte trois châssis 2 agencés sur le support 4, chaque châssis 2 étant destiné à recevoir un calculateur 3. Les trois châssis 2 sont adjacents les uns aux autres au niveau de leurs segments latéraux 6. De plus, chaque châssis 2 comprend un connecteur 11 fixé sur ledit châssis 2. Le bâti 1 comporte une pluralité de pièces de renfort 18. Chaque pièce de renfort 18 est agencée entre chaque châssis 2 et le connecteur 11 fixé audit châssis 2.

Grâce à la pluralité de pièces de renfort 18 on obtient un bâti d'équipement électrique renforcé capable de recevoir une pluralité de calculateurs 3 sans risque d'endommager le circuit imprimé 10.

Dans une première réalisation (non représentée et ne faisant pas partie de l'invention) de ce second mode de réalisation, les pièces de renfort 18 du bâti 1 sont indépendantes des unes des autres. Chaque pièce de renfort 18 peut ainsi être adaptée facilement à chaque châssis 2 et/ou aux efforts exercés sur le ou les connecteurs 11 (par le calculateur 3 et/ou le châssis 2).

Selon l'invention, les pièces de renfort 18 sont liées entre elles afin de former un ensemble rigide. Les pièces de renfort 18 peuvent par exemple être liées ensemble par des éléments rapportées.

Dans une troisième réalisation de ce second mode de réalisation, représentée sur la figure 4 et la figure 5, les pièces de renfort 18 forment une unité monobloc 28. L'unité monobloc 28 permet notamment de renforcer la rigidité au niveau de l'interface entre un calculateur 3 et un connecteur 11 et également de renforcer la rigidité entre les différents connecteurs 11. En effet, l'unité monobloc 28 permet d'éviter un endommagement du circuit imprimé 10 pouvant être causé par des mouvements relatifs entre les connecteurs 11, par exemple lorsque les calculateurs 3 exercent des efforts différents ou non simultanément sur les connecteurs 11.

La ou les pièces de renfort 18, selon l'un quelconque des modes de réalisation décrits ci-dessus, peuvent être obtenues facilement et à moindre coût par des procédés de fabrication usuels, par exemple par emboutissage.

Le bâti 1 (d'équipement électrique) comportant au moins une pièce de renfort 18, tel que décrit ci-dessus, présente de nombreux avantages. En particulier :
- il permet un transfert des efforts provenant du calculateur 3 et/ou du châssis 2 vers la pièce de renfort 18 et non pas vers le circuit imprimé 10 ;
- il permet d'assurer une liaison électrique entre le calculateur 3 et le circuit imprimé 10 sans risque d'endommager le circuit imprimé 10 ;
- il est léger et peu encombrant ;
- il permet d'obtenir un renfort structurel au niveau du connecteur 11 qui est facile et peu coûteux à mettre en oeuvre ;
- il permet d'éviter de modifier la conception de bâtis d'équipement électrique standards ; et
- il permet d'éviter des mouvements relatifs entre plusieurs calculateurs liés à un même circuit imprimé.

## Revendications

1. Bâti d'équipement électrique pour recevoir au moins un calculateur (3), ledit bâti (1) comportant au moins :
- une pluralité de châssis (2), chaque châssis (2) étant destiné à recevoir un calculateur (3) ;
- un circuit imprimé (10) pourvu de connecteurs (11) auxquels les calculateurs (3) installés sur les châssis (2) sont destinés à être connectés, au moins un connecteur (11) étant fixé à chacun des châssis (2) ; et
- une pluralité de pièces de renfort (18), au moins une pièce de renfort (18) étant agencée, au moins en partie, entre chaque châssis (2) et le ou les connecteurs (11) fixés audit châssis (2),
**caractérisé en ce que** lesdites pièces de renfort (18) sont liées ensemble et configurées pour rediriger des efforts que les calculateurs (3) et/ou les châssis (2) exercent sur les connecteurs (11), afin de ne pas transmettre lesdits efforts au circuit imprimé (10).

2. Bâti d'équipement électrique selon la revendication 1,
**caractérisé en ce que** les pièces de renfort (18) présentent au moins une paroi principale (19) plane agencée contre le châssis (2), la paroi principale (19) présentant un évidement (21) pour le passage de chaque connecteur (11) à travers les pièces de renfort (18).

3. Bâti d'équipement électrique selon la revendication 2,
**caractérisé en ce que** les pièces de renfort (18) comportent au moins une paroi latérale (22) sensiblement perpendiculaire à la paroi principale (19).

4. Bâti d'équipement électrique selon la revendication 3,
**caractérisé en ce que** la paroi latérale (22) présente au moins un bord latéral (24) incliné.

5. Bâti d'équipement électrique selon l'une quelconque des revendications 3 et 4,
**caractérisé en ce que** la paroi latérale (22) s'étend sur au moins une portion du pourtour de la paroi principale (19).

6. Bâti d'équipement électrique selon l'une quelconque des revendications 1 à 5,
**caractérisé en ce qu'**il comporte au moins un élément de fixation (17) pour fixer à la fois la pièce de renfort (18) et le connecteur (11) au châssis (2).

7. Bâti d'équipement électrique selon l'une quelconque des revendications précédentes,
**caractérisé en ce que** lesdites pièces de renfort (18) liées ensemble forment une unité monobloc (28).

## Patentansprüche

1. Rack für elektrische Ausrüstung, um mindestens einen Rechner (3) aufzunehmen, wobei das Rack (1) mindestens umfasst:
- eine Vielzahl von Rahmen (2), wobei jeder Rahmen (2) dazu bestimmt ist, einen Rechner (3) aufzunehmen;
- eine Leiterplatte (10), die mit Verbindern (11) versehen ist, mit denen die Rechner (3), die auf den Rahmen (2) installiert sind, bestimmungsgemäß verbunden werden sollen, wobei an jedem der Rahmen (2) mindestens ein Verbinder (11) befestigt ist; und
- eine Vielzahl von Verstärkungsteilen (18), wobei mindestens ein Verstärkungsteil (18) mindestens zum Teil zwischen jedem Rahmen (2) und dem oder den Verbindern (11), die am Rahmen (2) befestigt sind, angeordnet ist,
**dadurch gekennzeichnet, dass** die Verstärkungsteile (18) miteinander verbunden und so konfiguriert sind, dass sie Kräfte, die die Rechner (3) und/oder die Rahmen (2) auf die Verbinder (11) ausüben, umlenken, um die Kräfte nicht auf die Leiterplatte (10) zu übertragen.

2. Rack für elektrische Ausrüstung nach Anspruch 1,
**dadurch gekennzeichnet, dass** die Verstärkungsteile (18) mindestens eine ebene Hauptwand (19) aufweisen, die an dem Rahmen (2) angeordnet ist, wobei die Hauptwand (19) eine Aussparung (21) für den Durchtritt jedes Verbinders (11) durch die Verstärkungsteile (18) aufweist.

3. Rack für elektrische Ausrüstung nach Anspruch 2,
**dadurch gekennzeichnet, dass** die Verstärkungsteile (18) mindestens eine Seitenwand (22) umfassen, die im Wesentlichen senkrecht zur Hauptwand (19) steht.

4. Rack für elektrische Ausrüstung nach Anspruch 3,
**dadurch gekennzeichnet, dass** die Seitenwand (22) mindestens eine geneigte Seitenkante (24) aufweist.

5. Rack für elektrische Ausrüstung nach einem der Ansprüche 3 und 4,
**dadurch gekennzeichnet, dass** sich die Seitenwand (22) über mindestens einen Abschnitt des Umfangs der Hauptwand (19) erstreckt.

6. Rack für elektrische Ausrüstung nach einem der Ansprüche 1 bis 5,
**dadurch gekennzeichnet, dass** es mindestens ein Befestigungselement (17) umfasst, um sowohl das Verstärkungsteil (18) als auch den Verbinder (11) am Rahmen (2) zu befestigen.

7. Rack für elektrische Ausrüstung nach einem der vorstehenden Ansprüche,
**dadurch gekennzeichnet, dass** die miteinander verbundenen Verstärkungsteile (18) eine einstückige Einheit (28) bilden.

## Claims

1. An electrical equipment rack for receiving at least one computer (3), said rack (1) comprising at least :
- a plurality of chassis (2), each chassis (2) being designed to receive a computer (3);
- a printed circuit (10) provided with connectors (11) to which the computers (3) installed on the chassis (2) are intended to be connected, at least one connector (11) being fixed to each of the chassis (2); and
- a plurality of reinforcing pieces (18), at least one reinforcing piece (18) being arranged, at least in part, between each chassis (2) and the connector(s) (11) fixed to said chassis (2),
**characterised in that** said reinforcing pieces (18) are linked together and configured to redirect forces that the computers (3) and/or chassis (2) exert on the connectors (11), so as not to transmit said forces to the printed circuit (10).

2. The electrical equipment rack according to claim 1,
**characterised in that** the reinforcing pieces (18) have at least one plane main wall (19) arranged against the chassis (2), the main wall (19) having a recess (21) for the passage of each connector (11) through the reinforcing pieces (18).

3. The electrical equipment rack according to claim 2,
**characterised in that** the reinforcing pieces (18) comprise at least one side wall (22) substantially perpendicular to the main wall (19).

4. The electrical equipment rack according to claim 3,
**characterised in that** the side wall (22) has at least one inclined side edge (24).

5. The electrical equipment rack according to any one of claims 3 and 4,
**characterised in that** the side wall (22) extends over at least a portion of the periphery of the main wall (19).

6. The electrical equipment rack according to any one of claims 1 to 5,
**characterised in that** it comprises at least one fixing element (17) for fixing both the reinforcing piece (18) and the connector (11) to the chassis (2).

7. The electrical equipment rack according to any one of the preceding claims, **characterised in that** said reinforcing pieces (18) linked together form a single-piece unit (28).
